# EUROPEAN PATENT APPLICATION

(11) **EP 1 873 818 A2**
(43) Date of publication of application: **02.01.2008**
(21) Application number: 07111064.7
(22) Date of filing: 26.06.2007
(51) Int. Cl.: H01L 21/3105, H01L 21/316, C23C 16/40

(54) **Process for curing dielectric films**

(30) Priority: 27.06.2006 US 816896 P; 18.06.2007 US 764485
(71) Applicant: Air Products and Chemicals, Inc., Allentown, PA 18195-1501 (US)
(72) Inventor: Weigel, Scott Jeffrey, Allentown, PA 18104 (US); O'Neill, Mark Leonard, Allentown, PA 18104 (US); Vrtis, Raymond Nicholas, Orefield, PA 18069 (US); Haas, Mary Kathryn, Emmaus, PA 18049 (US); Karwacki, JR, Eugene Joseph, Orefield, PA 18069 (US)
(74) Representative: Hatt, Anna Louise

(57) **Abstract**

The present invention provides a process for forming a porous dielectric film, the process comprising: forming onto at least a portion of a substrate a composite film comprising Si, C, O, H and Si-CH₃ groups, wherein the composite film comprises at least one silicon-containing structure-forming material and at least one carbon-containing pore-forming material; and exposing the composite film to an activated chemical species to at least partially modify the carbon-containing pore-forming material, wherein at least 90% of Si-CH₃ species in the as deposited film remains in the film after the exposing step as determined by FTIR.

## Description

The present invention relates generally to the formation of porous films. More specifically, the invention relates to porous materials and films comprising same having a low dielectric constant and methods for making same.

There is a continuing desire in the microelectronics industry to increase the circuit density in multilevel integrated circuit devices such as memory and logic chips to improve the operating speed and reduce power consumption. In order to continue to reduce the size of devices on integrated circuits, the requirements for preventing capacitive crosstalk between the different levels of metallization becomes increasingly important. These requirements can be summarized by the expression "RC", whereby "R" is the resistance of the conductive line and "C" is the capacitance of the insulating dielectric interlayer. Capacitance "C" is inversely proportional to line spacing and proportional to the dielectric constant (k) of the interlayer dielectric (ILD). Such low dielectric materials are desirable for use, for example, as premetal dielectric layers or interlevel dielectric layers.

Undoped silica glass (SiO₂), subsequently referred to herein as "USG", has been long used in integrated circuits as a primary insulting material because of its relatively lower dielectric constant of approximately 4.0 compared to other inorganic materials. The industry has attempted to produce silica-based materials with lower dielectric constants by incorporating organics or other materials within the silicate lattice. For example, dielectric constants ranging from 2.7 to 3.5 can be achieved by incorporating terminal groups such as fluorine or methyl into the silicate lattice. These materials are typically deposited as dense films (density~ 1.5 g/cm³) and integrated within the IC device using process steps similar to those for forming USG films.

Since the dielectric constant of air is nominally 1.0, yet another approach to reducing the dielectric constant of a material may be to introduce porosity or reducing the density of the material. A dielectric film when made porous may exhibit lower dielectric constants compared to a relatively denser film.

Porosity has been introduced in low dielectric materials through a variety of different means. For example, porosity may be introduced by decomposing part of the film resulting in a film having an increased porosity and a lower density. Additional fabrication steps may be required for producing porous films that ultimately add both time and energy to the fabrication process. Minimizing the time and energy required for fabrication of these films is desirable; thus discovering materials that can be processed easily, or alternative processes that minimize processing time, is highly advantageous.

A method used extensively in the literature for introducing porosity into a film is thermal annealing to decompose at least a portion of the film thereby creating pores and ultimately lowering the dielectric constant. In the annealing step, or curing step, the film is typically heated to decompose and/or remove volatile components and substantially cross-link the film. U.S. Patent No. 6,312,793 describes a multiphasic material having a first phase consisting essentially of Si, C, O, and H, a second phase consisting essentially of C and H, and a multiplicity of pores. The material is optionally heated to a temperature of at least 300°C and for a time of at least 15 minutes to induce removal of one of the phases. Published Patent Application WO 00/02241 describes heating an alkoxysilane material at a temperature from 100 to 400 °C for a time of 1 to 10 minutes to induce formation of pores by removing the solvent contained therein. Published Patent Application WO 02/07191A2 describes heating a silica zeolite thin film to a temperature range of 350 to 550 °C for an unspecified amount of time to induce adsorbed material to leave the zeolitic framework thereby lowering the dielectric constant.

The majority of the aforementioned processes require curing steps at temperatures of 300°C or higher and times of 30 minutes or longer. A primary concern in the production of a low dielectric film may be the overall thermal budget of the IC device. Consequently, various components of IC devices such as Cu metal lines can only be subjected to processing temperatures for short time periods before their performance deteriorates due to undesirable diffusion processes.

An alternative to the thermal anneal or curing step is the use of ultraviolet ("UV") light in combination with an oxygen-containing atmosphere to create pores within the material and lower the dielectric constant. The references, Hozumi, A. et al. "Low Temperature Elimination of Organic Components from Mesostructured Organic-Inorganic Composite Films Using Vacuum Ultraviolet Light", Chem. Mater. 2000 Vol. 12, pp. 3842-47 ("Hozumi I") and Hozumi, A et al., "Micropatterned Silica Films with Ordered Nanopores Fabricated through Photocalcination", NanoLetters 2001, 1 (8), pp. 395-399 ("Hozumi II"), describe removing a cetyltrimethylammonium chloride (CTAC) pore-former from a tetraethoxysilane (TEOS) film using ultraviolet ("VUV") light (172 nm) in the presence of oxygen. The reference, Ouyang, M., "Conversion of Some Siloxane Polymers to Silicon Oxide by UV/Ozone Photochemical Processes", Chem. Mater. 2000, 12(6), pp. 1591-96, describes using UV light ranging from 185 to 254 nm to generate ozone *in situ* to oxidize carbon side groups within poly(siloxane) films and form a SiO₂ film. The reference, Clark, T., et al., "A New Preparation of UV-Ozone Treatment in the Preparation of Substrate-Supported Mesoporous Thin Films", Chem. Mater. 2000, 12(12), pp. 3879-3884, describes using UV light having a wavelength between 187 and 254 nm to produce ozone and atomic oxygen to remove organic species within a TEOS film. These techniques, unfortunately, may adversely affect the resultant film by chemically modifying the bonds that remain within the material. For example, exposure of these materials to an oxidizing atmosphere can result in the oxidation of the C atoms contained therein which has an adverse effect on the dielectric properties of the material.

U. S. Pat. No. 6,284,500 describes using UV light in the 230 to 350 nm wavelength range to photoinitiate cross-linking within an organic polymer film formed by CVD or an organosilsesquioxane film formed by spin-on deposition to improve the adhesion and mechanical properties of the film. The '500 patent teaches that a thermal annealing step may be used to stabilize the cross-linked film.

Published U. S. patent application No. 2003/054115 teaches UV curing a porous dielectric material produced by CVD or spin-on deposition methods to produce a UV-cured porous dielectric material having an improved modulus and comparable dielectric constant. This publication demonstrates that UV exposure in an O₂ atmosphere is more effective than UV exposure in a N₂ atmosphere. However, this publication also teaches that the UV cure can generate a notable amount of polar species in the porous dielectric materials. Further, this publication states that "in all cases a subsequent or possibly concomitant anneal step is necessary in order to remove the Si-OH bonds which are typically generated during the UV curing process."

U. S. Pat. No. 6,566,278 teaches densifying a carbon-doped, silicon oxide (SiCₓO_{y}) film by exposing the film to UV radiation. The carbon-doped silicon oxide film is deposited via chemical vapor deposition of an oxygen-supplying gas and an organosilane silicon supplying gas. The film is then exposed to UV radiation generated from an excited gas species such as xenon, mercury, deuterium, or KrCl₂.

U.S. patent application Publication Nos. 2004/0096593 and 2004/0175957 for example, provide a low temperature process to remove the organic pore-forming phase with UV light under non-oxidizing conditions while increasing the mechanical properties of the final porous film. The films can be deposited using a variety of techniques including CVD and spin-on.

Although beneficial, prior art UV curing processes are not free of drawbacks. For example, prior art UV curing processes typically employ an atmosphere that includes an inert gas and/or a vacuum during the cure. Under such conditions, residues that out-gas from the film collect on the windows and walls of the chamber. The material on the windows typically further adsorbs additional critical wavelengths that that may otherwise be needed for the process. In this regard, removal of this material is difficult and often requires severe and prolonged cleaning conditions such as, for example, cleaning in an oxidative environment.

Accordingly, there is a need in the art for a more efficient method to produce porous low dielectric films that enhances porogen removal that avoids the above-described processing drawbacks.

The present invention satisfies the need in the art for an enhanced porogen removal process to form porous low dielectric films. In particular, this need is satisfied by providing a process for forming a porous dielectric film, the process comprising: forming onto at least a portion of a substrate a composite film comprising Si, C, O, H and Si-CH₃ groups, wherein the composite film comprises at least one silicon-containing structure-forming material and at least one carbon-containing pore-forming material; and exposing the composite film to an activated chemical species to at least partially modify the carbon-containing pore-forming material, wherein at least 90% of Si-CH₃ species in the as deposited film remains in the film after the exposing step as determined by FTIR.

In another aspect, the present invention provides a process for forming a porous film, the process comprising: forming onto at least a portion of a substrate a composite film comprising Si, C, O, H and Si-CH₃ groups, wherein the composite film comprises at least one silicon-containing structure-forming material and at least one carbon-containing pore-forming material; and exposing the composite film concurrently to at least one energy source and an activated chemical species.

In another aspect, the present invention provides a process for modifying carbon in a dielectric film, the process comprising: forming onto at least a portion of a substrate a composite film comprising Si, C, O, H and Si-CH₃ groups, wherein the composite film comprises at least one silicon-containing structure-forming material and at least one carbon-containing pore-forming material; exposing the composite film to at least one energy source in cooperation with an activated chemical species for a time sufficient to modify at least a portion of the at least one carbon-containing pore-forming material to form a porous film, and wherein a carbon-containing residue forms upon the modification of at least a portion of the carbon in the film; and exposing the porous film to an activated chemical species to at least partially remove the carbon-containing residue.

The process of the present invention as described below, among other things, efficiently removes at least a portion of the at least one carbon-containing pore-forming material by enhancing the removal of the at least one carbon-containing pore-forming material; decreases the formation of material on the windows and walls of the chamber; lessens the time required to clean the chamber; improves the film properties such as, for example, the dielectric constant by promoting the removal of components that increase the dielectric constant of the film, including the pore-forming material; and may allow the cure process to function at lower temperatures.

Figure 1 depicts a hot filament CVD apparatus for use in accordance with the present invention; and

Figures 2a to 2c provide an illustration of the various steps of one embodiment of the present invention wherein the concurrent exposure to UV radiation energy and an activated chemical species results in the formation of pores within the film.

The present invention is directed to the preparation of porous low dielectric materials and films such as, for example, those employed as interlayer dielectrics in integrated circuits. In particular, the present invention is directed to a process for modifying carbon species in a composite film to thereby enhance the removal of the modified carbon species in an effort to lower the dielectric constant of the material or film. As used herein, the term "modifying" or "modify" refers to a change in form and/or amount. Thus, if a carbon species is "modified" according to the present invention, it may be at least partially removed or it may be, for example, at least partially chemically reduced, or bonds may otherwise be formed or broken. Typical carbon species according to the present invention include carbon-containing pore-forming materials as described in more detail below and carbon-containing residues that may form during removal of carbon-containing pore-forming materials from the composite film by an energy source and remain in the film. The carbon species in the film that is modified according to the present invention may also be carbon introduced during any subsequent processing of the dielectric film to produce the trenches and vias during the construction of electrical devices. This may include photoresists, wet chemical stripper components (corrosion inhibitors, salts, ionic buffers, pH buffers, solvents, etc.), CMP slurry components, CMP cleans, and other rinse steps.

The present invention provides a process for forming a porous dielectric film, the process comprising: forming onto at least a portion of a substrate a composite film comprising Si, C, O, H and Si-CH₃ groups, wherein the composite film comprises at least one silicon-containing structure-forming material and at least one carbon-containing pore-forming material; and exposing the composite film to an activated chemical species to at least partially modify the carbon-containing pore-forming material, wherein at least 90% of Si-CH₃ species in the as deposited film remains in the film after the exposing step as determined by FTIR. In some embodiments of the present invention, the porous organosilica glass film also comprises fluorine. In preferred embodiments, the porous film is a porous organosilica glass film consisting of a single phase of a material represented by the formula SiᵥO_{w}CₓH_{y}F_{z}, where v+w+x+y+z = 100%, v is from 10 to 35 atomic%, w is from 10 to 65 atomic%, x is from 5 to 30 atomic%, y is from 10 to 50 atomic% and z is from 0 to 15 atomic%, wherein the film has pores and a dielectric constant between 2.6 and 1.5.

The process of the present invention includes the step of forming onto at least a portion of a substrate a composite film comprising Si, C, O, H and Si-CH₃ groups, wherein the composite film comprises at least one silicon-containing structure-forming material and at least one carbon-containing pore-forming material. Suitable substrates for use according to the present invention include, but are not limited to, semiconductor materials such as gallium arsenide ("GaAs"), boronitride ("BN") silicon, and compositions containing silicon such as crystalline silicon, polysilicon, amorphous silicon, epitaxial silicon, silicon dioxide ("SiO₂"), silicon carbide ("SiC"), silicon oxycarbide ("SiOC"), silicon nitride ("SiN"), silicon carbonitride ("SiCN"), organosilicate glasses ("OSG"), organofluorosilicate glasses ("OFSG"), fluorosilicate glasses ("FSG"), and other appropriate substrates or mixtures thereof. Substrates according to the present invention may further comprise a variety of layers to which the film is applied thereto such as, for example, antireflective coatings, photoresists, organic polymers, porous organic and inorganic materials, metals such as copper and aluminum, or diffusion barrier layers, e.g., TiN, Ti(C)N, TaN, Ta(C)N, Ta, W, WN, or W(C)N. The porous films of the present invention are preferably capable of adhering to at least one of the foregoing materials sufficiently to pass a conventional pull test, such as an ASTM D3359-95a tape pull test.

As mentioned previously, the composite film comprises at least two materials: at least one silicon-containing structure-forming material and at least one carbon-containing pore-forming material. In preferred embodiments of the present invention, the at least one carbon-containing pore-forming material is dispersed within the silicon-containing structure-forming material. The term "dispersed" as used herein includes discrete areas of pore-forming material, air-gap interconnect structures *(i.e.,* relatively large areas of carbon-containing pore-forming material), bi-continuous areas of carbon-containing pore-forming material, structure forming materials, and combinations thereof.

The at least one silicon-containing structure-forming material of the composite film preferably comprises at least one compound that is capable of forming and maintaining an interconnecting network. Examples of these materials include, but are not limited to, undoped silicate glass (SiO₂), silicon carbide (SiC), hydrogenated silicon carbide (Si:C:H), silicon oxynitride (Si:O:N), silicon nitride (Si:N), silicon carbonitride (Si:C:N), fluorosilicate glass (Si:O:F), organofluorosilicate glass (Si:O:C:H:F), organosilicate glass (Si:O:C:H), diamond-like carbon, borosilicate glass (Si:O:B:H), or phosphorous doped borosilicate glass (Si:O:B:H:P). In certain preferred embodiments, the silicon-containing structure-forming material comprises a silica compound. The term "silica", as used herein, is a material that has silicon (Si) and oxygen (O) atoms, and possibly additional substituents such as, but not limited to, other elements such as C, H, B, N, P, or halide atoms; alkyl groups; or aryl groups. Regardless of whether or not the silicon-containing structure-former is unchanged throughout the process of the present invention, the term "silicon-containing structure-former" as used herein is intended to encompass structure-forming reagents, precursors (or structure-forming substituents) and derivatives thereof, in whatever forms they are found throughout the entire process of the invention.

The materials of the present invention may be formed into a composite film onto at least a portion of a substrate from a precursor composition or mixture using a variety of different methods. These methods may be used by themselves or in combination. Some examples of processes that may be used to form the composite film include the following: thermal chemical vapor deposition, plasma enhanced chemical vapor deposition ("PECVD"), high density PECVD, photon assisted CVD, plasma-photon assisted CVD, cryogenic chemical vapor deposition, chemical assisted vapor deposition, hot-filament chemical vapor deposition, CVD of a liquid polymer precursor, deposition from supercritical fluids, misted liquid deposition, or transport polymerization ("TP"). U. S. Pat. Nos. 6,171,945, 6,054,206, 6,054,379 and 6,159,871 and International Patent Application No. WO 99/41423 provide some exemplary CVD methods that may be used to form the composite film of the present invention. Other processes that can be used to form the film include spin coating, dip coating, Langmuir-blodgett self assembly, or misting deposition methods.

In certain embodiments, the composite film is formed from a mixture of one or more gaseous reagents in a chemical vapor deposition process. The phrase "gaseous reagent" (also referred to herein as a "precursor gas") is sometimes used herein to describe the reagents and is intended to encompass reagents delivered directly as a gas to the reactor, delivered as a vaporized liquid, a sublimed solid and/or transported by an inert carrier gas into the reactor. In other embodiments of the present invention, the composite film is formed through a PECVD process. Briefly, gaseous reagents are introduced into a reaction chamber such as a vacuum chamber and plasma energy energizes the gaseous reagents thereby forming a film on at least a portion of the substrate. In these embodiments, the composite film can be formed by the co-deposition, or alternatively the sequential deposition, of a gaseous mixture comprising at least one silica containing, preferably organosiloxane precursor, that forms the structure-forming material with at least one plasma-polymerizable organic precursor that forms the pore-forming material. In certain embodiments, the plasma energy applied may range from 0.02 to 7 watts/cm² or, alternatively, 0.3 to 3 watts/cm². For 200 mm diameter substrates, flow rates for each of the gaseous reagents may range from 10 to 5000 standard cubic centimeters per minute (sccm). Pressure values in the vacuum chamber during deposition for a PECVD process of the present invention may range from 0.01 to 600 torr (1 Pa to 80 kPa), more preferably 1 to 10 torr (100 Pa to 1.5 kPa). It is understood however that process parameters such as plasma energy, flow rate, and pressure may vary depending upon numerous factors such as the surface area of the substrate, the structure-forming and pore-forming materials to be formed, the equipment used in the PECVD process, etc.

In a certain preferred embodiment of the present invention wherein the composite film comprises Si, C, O, H and Si-CH₃ groups, the composite film is formed by providing a substrate within a vacuum chamber; introducing into the vacuum chamber gaseous reagents that comprise at least one silicon-containing structure-forming precursor gas selected from an organosilane and an organosiloxane; a carbon-containing pore-forming precursor distinct from the at least one silicon-containing structure-former precursor gas selected from an organosilane and an organosiloxane; and optionally at least one precursor gas including a fluorine-providing gas that may form at least a portion of the silicon-containing structure-former; and applying energy to the gaseous reagents in said chamber to induce reaction of the gaseous reagents and to form the film on the substrate. Examples of gaseous reagents used as structure-forming and pore-forming precursors may be found in U.S. Patent Nos. 6,583,048 and 6,846,515, which are commonly assigned to the assignee of the present invention.

Silica-containing gases such as organosilanes and organosiloxanes are the preferred silicon-containing structure-forming precursor gases to form the structure-forming material of the chemical vapor deposited composite film. Suitable organosilanes and organosiloxanes include, e.g.: (a) alkylsilanes represented by the formula R¹ₙSiR²₄₋ₙ, where n is an integer from 1 to 3; R¹ and R² are independently at least one branched or straight chain C₁ to C₈ alkyl group (e.g., methyl, ethyl), a C₃ to C₈ substituted or unsubstituted cycloalkyl group (e.g., cyclobutyl, cyclohexyl), a C₃ to C₁₀ partially unsaturated alkyl group (e.g., propenyl, butadienyl), a C₆ to C₁₂ substituted or unsubstituted aromatic (e.g., phenyl, tolyl), a corresponding linear, branched, cyclic, partially unsaturated alkyl, or aromatic containing alkoxy group (e.g., methoxy, ethoxy, phenoxy), and R² is alternatively hydride (e.g., methylsilane, dimethylsilane, trimethylsilane, tetramethylsilane, phenylsilane, methylphenylsilane, cyclohexylsilane, tert-butylsilane, ethylsilane, diethylsilane, tetraethoxysilane, dimethyldiethoxysilane, diethoxymethylsilane (DEMS^{™}), dimethyldimethoxysilane, dimethylethoxysilane, methyldiethoxysilane, triethoxysilane, trimethylphenoxysilane and phenoxysilane); (b) a linear organosiloxane represented by the formula R¹(R²₂SiO)ₙSiR²₃ where n is an integer from 1 to 10, or cyclic organosiloxane represented by the formula (R¹R²SiO)ₙ where n is an integer from 2 to 10 and R¹ and R² are as defined above (e.g., 1,3,5,7-tetramethylcyclotetrasiloxane, octamethylcyclotetrasiloxane, hexamethylcyclotrisiloxane, hexamethyldisiloxane, 1,1,2,2-tetramethyldisiloxane, and octamethyltrisiloxane); and (c) a linear organosilane oligomer represented by the formula R²(SiR¹R²)ₙR² where n is an integer from 2 to 10, or cyclic organosilane represented by the formula (SiR¹R²)ₙ, where n is an integer from 3 to 10, and R¹ and R² are as defined above (e.g., 1,2-dimethyldisilane, 1,1,2,2-tetramethyldisilane, 1,2-dimethyl-1,1,2,2-dimethoxydisilane, hexamethyldisilane, octamethyltrisilane, 1,2,3,4,5,6-hexaphenylhexasilane, 1,2-dimethyl-1,2-diphenyldisilane and 1,2-diphenyldisilane). In certain embodiments, the organosilane/organosiloxane is a cyclic alkylsilane, a cyclic alkylsiloxane, a cyclic alkoxysilane or contains at least one alkoxy or alkyl bridge between a pair of Si atoms, such as 1,2-disilanoethane, 1,3-disilanopropane, dimethylsilacyclobutane, 1,2-bis(trimethylsiloxy)cyclobutene, 1,1-dimethyl-1-sila-2,6-dioxacyclohexane, 1,1-dimethyl-1-sila-2-oxacyclohexane, 1,2-bis(trimethylsiloxy)ethane, 1,4-bis(dimethylsilyl)benzene, octamethylcyclotetrasiloxane (OMCTS), or 1,3-(dimethylsilyl)cyclobutane. In certain embodiments, the organosilane/organosiloxane contains a reactive side group selected from an epoxide, a carboxylate, an alkyne, a diene, phenyl ethynyl, a strained cyclic group and a C₄ to C₁₀ group which can sterically hinder or strain the organosilane/organosiloxane, such as trimethylsilylacetylene, 1-(trimethylsilyl)-1,3-butadiene, trimethylsilylcyclopentadiene, trimethylsilylacetate and di-tert-butoxydiacetoxysilane.

In certain embodiments, the at least one structure-forming material further comprises fluorine. Preferred fluorine-providing gases for a CVD-deposited composite film lack any F-C bonds (i.e., fluorine bonded to carbon) that could end up in the film. Thus, preferred fluorine-providing gases include, e.g., SiF₄, NF₃, F₂, HF, SF₆, CIF₃, BF₃, BrF₃, SF₄, NF₂Cl, FSiH₃, F₂SiH₂, F₃SiH, organofluorosilanes and mixtures thereof, provided that the organofluorosilanes do not include any F-C bonds. Additional preferred fluorine-providing gases include the above mentioned alkylsilanes, alkoxysilanes, linear and cyclic organosiloxanes, linear and cyclic organosilane oligomers, cyclic or bridged organosilanes, and organosilanes with reactive side groups, provided a fluorine atom is substituted for at least one of the silicon substituents, such that there is at least one Si-F bond. More specifically, suitable fluorine-providing gases include, e.g., fluorotrimethylsilane, difluorodimethylsilane, methyltrifluorosilane, fluorotriethoxysilane, 1,2-difluoro-1, 1,2,2,-tetramethyldisilane, or difluorodimethoxysilane.

In embodiments where the composite film is formed through a spin-on approach, the composite film is formed from a mixture that comprises, *inter alia,* at least one silicon-containing structure-forming precursor, preferably a silica source, a carbon-containing pore-forming precursor or pore-former, a catalyst, and water. The mixture may further comprise a solvent and a surfactant. In brief, dispensing the mixture onto a substrate and evaporating the solvent and water can form the composite film. The surfactant, remaining solvent and water, and pore-former are generally removed by exposing the coated substrate to one or more energy sources and for a time sufficient to produce the low dielectric film. In some instances, the composite film may be pre-heated to substantially complete the hydrolysis of the silica source, continue the cross linking process, and drive off any remaining solvent, if present, from the film.

In certain preferred embodiments, the mixture used to form the composite film preferably comprises a silica source that forms the structure-forming material. A "silica source", as used herein, is a compound having silicon (Si) and oxygen (O), and possibly additional substituents such as, but not limited to, other elements such as H, B, C, P, or halide atoms; alkyl groups; or aryl groups. The term "alkyl" as used herein includes straight chain, branched, or cyclic alkyl groups, preferably containing from 1 to 24 carbon atoms, or more preferably from 1 to 13 carbon atoms. This term applies also to alkyl moieties contained in other groups such as haloalkyl, alkaryl, or aralkyl. The term "alkyl" further applies to alkyl moieties that are substituted or may be partially unsaturated. The term "aryl" as used herein includes six to twelve member carbon rings having aromatic character. The term "aryl" also applies to aryl moieties that are substituted. The silica source may include materials that have a high number of Si-O bonds, but can further include Si-O-Si bridges, Si-R-Si bridges, Si-C bonds, Si-F bonds, Si-H bonds or a portion of the material can also have C-H bonds. Other examples of the silica source may include a fluorinated silane or fluorinated siloxane such as those provided in U. S. Pat. No. 6,258,407.

Another example of a silica source may include compounds that produce a Si-H bond upon removal of the pore-forming material.

Still further examples of the source are found in the non-hydrolytic chemistry methods described, for example, in the references Hay et al., "Synthesis of Organic-Inorganic Hybrids via the Non-hydrolytic Sol-Gel Process", Chem. Mater., 13, 3396-3403 (2001) or Hay, et al., "A Versatile Route to Organically-Modified Silicas and Porous Silicas via the Non-Hydrolytic Sol-Gel Process", J. Mater. Chem., 10, 1811-1818 (2000).

Still other examples of silica sources include silsesquioxanes such as hydrogen silsesquioxanes (HSQ, HSiO_{1.5}) and methyl silsesquioxanes (MSQ, RSiO_{1.5} where R is a methyl group).

Further examples of the suitable silica sources include those described in U. S. Pat. No. 6,271,273 and EP Nos. 1,088,868; 1,123,753, and 1,127,929. In preferred embodiments, the silica source may be a compound represented by the following: RₐSi(OR¹)₄₋ₐ, wherein R represents a hydrogen atom, a fluorine atom, or a monovalent organic group; R¹ represents a monovalent organic group; and a is an integer of 1 or 2; Si(OR²)₄, where R² represents a monovalent organic group; or R³_{b}(R⁴O)_{3-b}Si-(R⁷)_{d}-Si(OR⁵)_{3-c}R⁶_{c}, wherein R³ to R⁶ may be the same or different and each represents a monovalent organic group; b and c may be the same or different and each is a number of 0 to 2; R⁷ represents an oxygen atom, a phenylene group, or a group represented by - (CH₂)ₙ-, wherein n is an integer of 1 to 6; and d is 0 or 1; or combinations thereof. The term "monovalent organic group" as used herein relates to an organic group bonded to an element of interest, such as Si or O, through a single C bond, i.e., Si-C or O-C.

In certain embodiments, the silica source may be added to the mixture as the product of hydrolysis and condensation. Hydrolysis and condensation of the silica source occurs by adding water and a catalyst to a solvent and adding the silica source at a time, intermittently or continuously, and conducting hydrolysis and condensation reactions while stirring the mixture at a temperature range generally from -30 to 100 °C, preferably from 20 to 100 °C, for 0 to 24 hours. The composition can be regulated to provide a desired solid content by conducting concentration or dilution with the solvent in each step of the preparation. Further, the silica source may be a compound that generates acetic acid when hydrolyzed.

The hydrolysis and condensation of the silica source can occur at any point during the formation of the composite film, i.e., before adding to the mixture, after adding to the mixture, prior to, and/or during exposure to at least one energy source, etc. For example, in certain embodiments of the present invention, the one silica source is combined with the solvent, water, and surfactant in a vessel and the catalyst is gradually added into the vessel and mixed. It is envisioned that a variety of different orders of addition to the mixture can be used without departing from the scope of the present invention.

Catalysts suitable for use in the present invention include any organic or inorganic acid or base that can catalyze the hydrolysis of substituents from the silica source in the presence of water, and/or the condensation of two silica sources to form a Si-O-Si bridge. The catalyst can be an organic base such as, but not limited to, quaternary ammonium salts and hydroxides, such as ammonium or tetramethylammonium, amines such as primary, secondary, and tertiary amines, and amine oxides. The catalyst can also be an acid such as, but not limited to, nitric acid, maleic, oxalic, acetic, formic, glycolic, glyoxalic acid, or mixtures thereof. In preferred embodiments, the catalyst comprises nitric acid.

Solvents that are suitable for the use in the present invention may include any solvents that solubilize the reagents thereby facilitating reaction. Solvents can be, for example, alcohol solvents, ketone solvents, amide solvents, or ester solvents. In certain embodiments the solvents may be a supercritical fluid such as carbon dioxide, fluorocarbons, sulfur hexafluoride, alkanes, and other suitable multi-component mixtures, etc. In certain embodiments, one or more solvents used in the present invention have relatively low boiling points, i.e., below 160°C. These solvents include, but are not limited to, tetrahydrofuran, acetone, 1,4-dioxane, 1,3-dioxolane, ethyl acetate, and methyl ethyl ketone. Other solvents, that can be used in the present invention but have boiling points above 100°C, include dimethylformamide, dimethylacetamide, N-methyl pyrrolidone, ethylene carbonate, propylene carbonate, glycerol and derivatives, naphthalene and substituted versions, acetic acid anhydride, propionic acid and propionic acid anhydride, dimethyl sulfone, benzophenone, diphenyl sulfone, phenol, m-cresol, dimethyl sulfoxide, diphenyl ether, terphenyl, and the like. Preferred solvents include propylene glycol propyl ether (PGPE), 3-heptanol, 2-methyl-1-pentanol, 5-methyl-2-hexanol, 3-hexanol, 2-heptanol, 2-hexanol, 2,3-dimethyl-3-pentanol, propylene glycol methyl ether acetate (PGMEA), ethylene glycol n-butyl ether, propylene glycol n-butyl ether (PGBE), 1-butoxy-2-propanol, 2-methyl-3-pentanol, 2-methoxyethyl acetate, 2-butoxyethanol, 2-ethoxyethyl acetoacetate, 1-pentanol, and propylene glycol methyl ether. Still further exemplary solvents include lactates, pyruvates, and diols. Further exemplary solvents include those solvents listed in EP 1,127,929. The solvents enumerated above may be used alone or in combination of two or more solvents.

The mixture used to form the composite films of the present invention further comprises one or more carbon-containing pore-forming precursors that produce pore-forming materials that are capable of being easily removed from the composite film upon exposure to one or more energy sources to the extent desired in view of the particular application. The carbon-containing pore-forming material is also referred to herein as a "porogen". As used herein, the terms "pore-forming material", "pore-former" or "porogen" refer to a carbon-containing reagent that is used to generate void volume within the resultant film. Such terms may also refer to the carbon-containing pore-forming precursor gas. Regardless of whether or not the pore-former is unchanged throughout the inventive process, the term "pore-former" as used herein is intended to encompass carbon-containing pore-forming reagents, precursors, (or pore-forming substituents) and derivatives thereof, in whatever forms they are found throughout the entire process of the invention. Suitable compounds to be used as the carbon-containing pore-forming material of the present invention include, but are not limited to, hydrocarbon materials, plasma-polymerized organic materials, labile organic groups, solvents, decomposable polymers, surfactants, dendrimers, hyper-branched polymers, polyoxyalkylene compounds, or combinations thereof.

In subsequent process steps, the carbon-containing pore-forming material is used to generate void volume within the resultant porous film upon its removal. The carbon-containing pore-forming material in the composite film may or may not be in the same form as the carbon-containing pore-forming precursor within the mixture and/or introduced to the reaction chamber. As well, the pore-former removal process may liberate the pore-former or fragments thereof from the film. In essence, the carbon-containing pore-forming precursor, the pore-former in the composite film, and the pore-former being removed may or may not be the same species, although it is preferable that they all originate from the pore-forming precursor. In preferred embodiments of the present invention, the carbon-containing pore-former (also referred to herein as a "pore-former precursor gas") is a hydrocarbon compound or plasma-polymerizable organic compound. Exemplary hydrocarbon compounds and plasma-polymerizable organic compounds include at least one of the following:
a cyclic hydrocarbon having a cyclic structure and the formula CₙH₂ₙ, where n is 3 to 20, a number of carbons in the cyclic structure is between 3 and 20, and the at least one cyclic hydrocarbon optionally contains a plurality of simple or branched hydrocarbons substituted onto the cyclic structure;
a linear or branched, saturated, singly or multiply unsaturated hydrocarbon of the general formula CₙH_{(2n+2)-2y} where n is a number ranging from 2 to 20 and where y is a number ranging from 0 to n;
a singly or multiply unsaturated cyclic hydrocarbon having a cyclic structure and the formula CₙH₂ₙ₋₂ₓ. where x is a number of unsaturated sites, n is a number ranging from 3 to 20, wherein the number of carbons in the cyclic hydrocarbon ranges from 3 to 20, and the at least one singly or multiply unsaturated cyclic hydrocarbon optionally contains a plurality of simple or branched hydrocarbons substituents on the cyclic structure, and contains endocyclic unsaturation or unsaturation on one of the hydrocarbon substituents;
a bicyclic hydrocarbon having a bicyclic structure and the formula CₙH₂ₙ₋₂, where n is a number ranging from 3 to 20, wherein a number of carbons in the bicyclic hydrocarbon structure ranges from 3 to 20, and the at least one bicyclic hydrocarbon optionally contains a plurality of simple or branched hydrocarbons substituted onto the bicyclic structure;
a multiply unsaturated bicyclic hydrocarbon having a bicyclic structure and the formula CₙH₂ₙ₋₍₂₊₂ₓ₎, where x is a number of unsaturated sites, n is a number ranging from 3 to 20, wherein a number of carbons in the multiply unsaturated bicyclic hydrocarbon structure is from 3 to 20, and the at least one multiply unsaturated bicyclic hydrocarbon optionally contains a plurality of simple or branched hydrocarbons substituents substituted onto the bicyclic structure, and contains endocyclic unsaturation and/or unsaturation on one of the hydrocarbon substituents;
a tricyclic hydrocarbon having a tricyclic structure and the formula CₙH₂ₙ₋₄, where n is a number ranging from 5 to 20, wherein a number of carbons in the tricyclic structure ranges from 5 to 20, and the at least one tricyclic hydrocarbon optionally contains a plurality of simple or branched hydrocarbons substituted onto the cyclic structure; and
a multiply unsaturated tricyclic hydrocarbon having a tricyclic structure and the formula CₙH₂ₙ₋₍₄₊₂ₓ₎, where x is a number of unsaturated sites, n is a number ranging from 3 to 20, wherein a number of carbons in the multiply unsaturated tricyclic hydrocarbon structure is from 3 to 20, and the at least one multiply unsaturated tricyclic hydrocarbon optionally contains a plurality of simple or branched hydrocarbons substituents substituted onto the tricyclic structure, and contains endocyclic unsaturation and/or unsaturation on one of the hydrocarbon substituents.

Examples of the aforementioned compounds include, but are not limited to, alpha-terpinene, limonene, cyclohexane, gamma-terpinene, camphene, dimethylhexadiene, ethylbenzene, norbornadiene, cyclopentene oxide, cyclohexene oxide, cyclohexanone, cyclopentanone, 1,2,4-trimethylcyclohexane, 1,5-dimethyl-1,5-cyclooctadiene, camphene, adamantane, 1,3-butadiene, substituted dienes, alpha-pinene, beta-pinene, and decahydronaphthelene, cyclooctane, cyclooctene, cyclooctadiene, cycloheptane, cycloheptene, dimethylhexadiene, and mixtures thereof.

The pore-former could also be a decomposable polymer. The decomposable polymer may be radiation decomposable or thermally decomposable. The term "polymer", as used herein, also encompasses the terms oligomers and/or copolymers unless expressly stated to the contrary. Radiation decomposable polymers are polymers that decompose upon exposure to radiation, e.g., ultraviolet, X-ray, electron beam, or the like. Thermally decomposable polymers undergo thermal decomposition at temperatures that approach the condensation temperature of the silica source materials and are present during at least a portion of the cross-linking. Such polymers are that which foster templating of the vitrification reaction, control and define pore size, and decompose and diffuse out of the matrix at the appropriate time in processing. Examples of these polymers include polymers that have an architecture that provides a three-dimensional structure such as, but not limited to, block copolymers, i.e., diblock, triblock, and multiblock copolymers; star block copolymers; radial diblock copolymers; graft diblock copolymers; cografted copolymers; dendrigraft copolymers; tapered block copolymers; and combinations of these architectures. Further examples of degradable polymers are found in U.S. Pat. No. 6,204,202.

The carbon-containing pore-forming material of the present invention could also comprise a surfactant. For silica sol-gel based films in which the porosity is introduced by the addition of surfactant that is subsequently removed, varying the amount of surfactant can vary porosity. The surfactants can be anionic, cationic, nonionic, or amphoteric. Further classifications of surfactants include silicone surfactants, poly(alkylene oxide) surfactants, and fluorochemical surfactants. However, for the formation of dielectric layers for IC applications, non-ionic surfactants are generally preferred. Further exemplary surfactants include alcohol (primary and secondary) ethoxylates, acetylenic diols and alcohols, phenol-based ethoxylates, amine ethoxylates, glucosides, glucamides, polyethylene glycols, poly(ethylene glycol-co-propylene glycol), or other surfactants provided in the reference

McCutcheon's Emulsifiers and Detergents, North American Edition for the Year 2000 published by Manufacturers Confectioners Publishing Co. of Glen Rock, N.J.

The pore-forming material may be a hyper branched or dendrimeric polymer. Hyper branched and dendrimeric polymers generally have low solution and melt viscosities, high chemical reactivity due to surface functionality, and enhanced solubility even at higher molecular weights. Some non-limiting examples of suitable decomposable hyper-branched polymers and dendrimers are provided in "Comprehensive Polymer Science", 2nd Supplement, Aggarwal, pp. 71-132 (1996).

The pore-forming material within the film-forming mixture may also be a polyoxyalkylene compound such as polyoxyalkylene non-ionic surfactants, polyoxyalkylene polymers, polyoxyalkylene copolymers, polyoxyalkylene oligomers, or combinations thereof. An example of such is a polyalkylene oxide that includes an alkyl moiety ranging from C₂ to C₆ such as polyethylene oxide, polypropylene oxide, and copolymers thereof.

In certain embodiments of the present invention, a single species of molecule may function as both the structure-former and pore-former within the composite film. That is, the structure-forming precursor and the pore-forming precursor are not necessarily different molecules, and in certain embodiments, the pore-former is a part of (e.g., covalently bound to) the structure-forming precursor. Examples of these materials may be found, for example, in U.S. Pat. Nos. 6,583,048 and 6,846,515. Precursors containing pore-formers bound to them are sometimes referred to hereinafter as "porogenated precursors". For example, the precursor neohexyl TMCTS may be used as both the structure-former and pore-former precursor, whereby the TMCTS portion of the molecule forms the base OSG structure and the bulky alkyl substituent neohexyl is the pore-forming species which is removed during the anneal process. In these embodiments, the attachment of the pore-former species attached to the Si species that can network into the OSG structure may be advantageous in achieving a higher efficiency of incorporation of pore-former into the film during the deposition process. Furthermore, it may also be advantageous to have two pore-formers attached to one Si in the precursor, such as in di-neohexyl-diethoxysilane, or two Si's attached to one pore-former, such as in 1,4-bis(diethoxysilyl)cyclohexane. While not intending to be bound by theory, the reaction of one Si-pore-former bond in the plasma may enable the incorporation of the second pore-former group into the deposited film.

In certain embodiments of the invention wherein a single or multiple pore-former is attached to silicon, it may be advantageous to design the pore-former such as that when the film is cured to form the pores, a part of the pore-former remains attached to the silicon to impart hydrophobicity to the film. The pore-former in a precursor containing Si-pore-former may be chosen such that decomposition or curing leaves a terminal chemical group from the pore-former, such as a -CH₃, attached to the silicon atom. For example, if the pore-former neopentyl is chosen, it is believed that thermal annealing under the proper conditions may break the C-C bonds beta to the Si; it is the bond between the secondary carbon adjacent to Si and the quaternary carbon of the t-butyl group that may be thermodynamically most favorable to break. Under proper conditions, it is believed that this would leave a terminal -CH₃ group bonded to the Si, as well as provide hydrophobicity and a low dielectric constant to the film. Examples of such precursors include neopentyl triethoxysilane, neopentyl diethoxy silane, neopentyl diethoxymethylsilane and dineopentylethoxymethyl silane.

In certain embodiments, the process of the present invention includes the step of exposing the composite film to an activated chemical species to at least partially modify the carbon in the composite film. According to the present invention, the activated chemical species can be provided by, for example, exposing a gas to, e.g., a radio frequency energy or microwave energy source to form a plasma, a hot filament energy source, an electron attachment energy source, or e-beam. The activated species may be generated by a remote energy source or by an *in situ* energy source. The time of the exposing step can be, for example, from less than 0.1 seconds to greater than 10 minutes.

In embodiments of the present invention where the activated chemical species is provided by generating reactive species by exposure to a plasma, the particular components of the plasma gas mixture are selected by their ability to form a gas and plasma under plasma forming conditions. The gas mixture may include reactive gases such as a fluorine-bearing gas, a hydrogen-bearing gas, and mixtures thereof. The gas may further comprise an inert gas such as argon, helium, nitrogen, xenon, krypton, neon and the like. The plasma generated from the gas primarily reacts with carbon and other atoms that are components of the porogen to form volatile compounds and aid in the porogen diffusion out of the film.

Where plasma embodiments are concerned, the reactive chemical species according to the present invention preferably is generated from a remote plasma generator. An example of a remote plasma generator is a downstream plasma generator such as for example, a microwave plasma generator commercially available under the trade name Fusion GEMINI ES® from the Axcelis Technologies, Inc. in Rockville, Md. Other remote plasma generators can include a plasma generator employing an inductively coupled plasma reactor.

The settings and optimization for particular plasma generator will be well within the skill of those in the art in view of this disclosure. Plasma generators generally are comprised of a plasma generating chamber and a plasma reaction chamber. For exemplary purposes only, in a 300 mm Fusion ES3 downstream plasma generator, the substrates are preferably heated in the reaction chamber to a temperature of 450°C or less, more preferably between 150°C and 450°C, and most preferably between 250°C and 400°C. The temperatures used during processing may be constant or alternatively, ramped or stepped during processing. The pressure within the reaction chamber is preferably reduced to 1 torr (100 Pa) or more. In certain embodiments of the present invention, the pressure is operated in a range from 1 torr to 4 torr (100 to 550 Pa). An excitable gas mixture is fed into the plasma-generating chamber via a gas inlet. Preferably, the gas mixture from which the activated chemical species comprises a reducing agent selected from H₂, CO, CₓH_{y}, CO₂, and mixtures thereof. Other compounds can also be used as reducing agents according to the present invention. Such other compounds include hydrazine and its derivatives, sulfur and its oxides, H₂S, hydrides, boranes, ammonia, silane, phosphine, arsine, stibine, and mixtures thereof.

The gas mixture is typically exposed to an energy source within the plasma-generating chamber, e.g., radio frequency energy to generate excited or energetic atoms from the gas mixture. The generated plasma is comprised of electrically neutral and charged particles formed from the gases used in the plasma gas mixture. In certain embodiments of the present invention, the charged particles are selectively removed prior to plasma reaching the wafer. In certain embodiments of the present invention, the gas mixture for forming the plasma includes a hydrogen, helium, and optionally fluorine gases. Alternatively, the gas mixture includes a mixture of hydrogen and helium.

In preferred embodiments of the present invention, the activated chemical species is provided by generating reactive species by exposure to a hot filament such as that employed in, for example, a hot-filament chemical vapor deposition ("HFCVD") apparatus. An advantage of employing a hot filament energy source in the process of the present invention is that the gaseous reagents (i.e., the components of the fluid) are very efficiently cracked into atomic radicals at the surface of the hot filament (usually tungsten, platinum, rhenium, or tantalum) if it is kept at a temperature that is significantly higher than 1500°C. The reactive species are transported to the substrate in a low pressure ambient which enables reaction with the film.

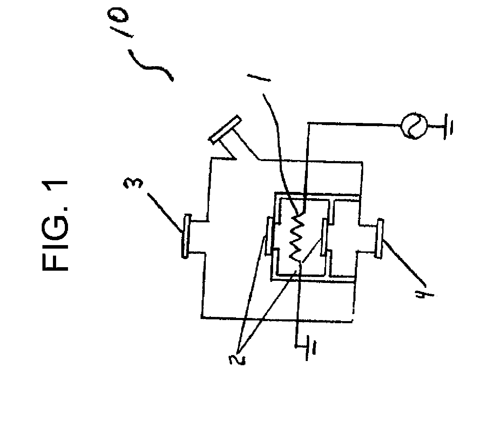

A process employing a hot filament according to the present invention is described herein with reference to the apparatus depicted in FIG. 1. Although FIG. 1 portrays a particular reactor 10, the following description is generally applicable regardless of reactor specifics. The fluid enters the reactor 10 via inlet 3. Reactor pressure is typically maintained via an automatically controlled throttle valve connected at outlet 4 prior to a vacuum pump not otherwise shown. Reactor pressure is typically maintained in the region of 1 torr up to 1 atmosphere (100 Pa to 100 kPa). Lower pressure typically affords faster diffusion of reactive species but also a lower concentration of reactive species. The optimum pressure for any given set of conditions will be determined experimentally without excessive effort. Filament 1, which has a high melting point, is heated to a sufficiently high temperature so that the gaseous reagents are dissociated to provide reactive species. Filament 1 is typically about 1.5 mm in diameter and is shown as a spiral that is about 2.5cm in length; however, it is not a particularly critical variable and is susceptible to very broad variation. For example, where the substrate is large the spiral can be wider to cover virtually the entire surface of the substrate, or more than one filament may be used. In any case, the filament needs to be heated to a temperature which will cause decomposition of the gaseous reagents with production of reactive species. A filament temperature in the range of 900-2400 °C, and preferably 2000-2400 °C, typically can be readily achieved in, e.g., tungsten filaments by passing AC or DC current through the filament. In general the filament is typically heated to a temperature just short of its maximum operating temperature. Generally reagent flow into the reactor is established prior to heating the filament.

Substrate 2 comprising a composite film as described above is typically placed proximate to but at a distance from filament 1. The appropriate distance between the substrate and heated filament also is experimentally determined, and may depend, inter alia, on the reagents, filament temperature, reactor pressure, substrate temperature, and the presence of a catalyst, but generally is on the order of several millimeters to a few centimeters. A substrate temperature of 300-1000 °C is typical, although substrate temperatures in the range of 200°C up to 1200°C may be employed. Once reagent flow is established and equilibrium has been reached with respect to the fluid and the composite film, the filament is heated to 2000°C or more. Once the filament is heated, the fluid becomes activated and comes into contact with the composite film to modify the carbon in the composite film.

In other embodiments of the present invention, the activated chemical species is provided by generating a reactive species comprising negatively charged ions by exposure to an electron attachment energy source. To produce negatively charged ions by electron attachment, a large quantity of electrons needs to be generated. In this connection, the electrons can be generated by a variety of ways such as, but not limited to, cathode emission, gas discharge, or combinations thereof. Among these electron generation methods, the selection of the method depends mainly on the efficiency and the energy level of the electrons generated.

In electron attachment, a gas mixture of an inert gas such as, for example, nitrogen, and a reducing gas, such as, for example, hydrogen or carbon monoxide, is introduced into a heating chamber, oven or a furnace with a cathode and anode and the composite film is connected to or mounted on the anode to form a target assembly. When a DC voltage is applied between the cathode and the anode, low-energy electrons (i.e., 10 eV or less) are generated at the cathode and drift to the anode in the electric field. During this electron drift, a part of the molecular reducing gas, e.g., H₂, can form negative ions by electron attachment and then drift to the anode. At the anode, the negatively charged ionic hydrogen contacts the carbon in the composite to modify the carbon to, for example, at least partially remove it or chemically reduce the carbon. During this process, the inert gas, e.g., N₂, is not affected because the electron affinity of nitrogen is zero.

For the present invention, the H₂ concentration in the gas mixture may be comprised between 0.1 to 100% by volume, and more preferably between 0.5 to 50% by volume. The temperature may range between ambient to 400°C, and more favorably between 100 to 350 °C. The DC voltage may comprise between -1 to -50 kV, and the preferred range is between -2 to -30 kV. The distance between the cathode and the top surface of the composite film may be 1 to 10 cm, and the preferred range is 2 to 5 cm. The cathode or device from which the electrons are generated (photoemissive or radioactive source) should be close to the anode or target assembly and does not require a separate chamber or zone but a remote chamber may be employed. The pressure in the electron attachment apparatus is preferably ambient atmospheric pressure, meaning the existing pressure of the area of the process. No special pressure, such as vacuum, is required. Typically, pressures of 10 to 20 psia (60 to 140 kPa) would be acceptable, but a pressure of 14 to 16 psia (95 to 110 kPa), preferably 14.7 psia (101 kPa), is most appropriate. Electron attachment technology is described in more detail in U.S. Patent No. 6,776,330 and U.S. patent application Publication No. 2004/0211675.

In certain preferred embodiments of the present invention, the activated chemical species comprises at least one hydrogen-bearing gas. Hydrogen-bearing gases suitable for use in the process include those compounds that contain hydrogen. The hydrogen-bearing gases include hydrocarbons, hydrofluorocarbons, hydrogen gas or mixtures thereof. Preferred hydrogen-bearing gases exist in a gaseous state at standard temperature and pressure conditions. The hydrocarbons or hydrofluorocarbons are generally unsubstituted or may be partially substituted with a halogen such as bromine, chlorine or fluorine. Examples of hydrogen-bearing hydrocarbon gases include methane, ethane and propane.

Preferred hydrocarbons for use as the activated chemical species include C₁₋₁₀ linear or branched, cyclic or multicyclic, saturated, or unsaturated hydrocarbons.

In certain preferred embodiments of the present invention, the activated chemical species may comprise at least one species known to be typically employed in the art as a reducing agent. Such reducing agents include H₂, hydrazine and its derivatives, sulfur and its oxides, H₂S, hydrides, boranes, ammonia, amines, silanes, organosilanes, phosphine, arsine, stibine, and mixtures thereof. Hydrogen and/or hydrogen-bearing gases are particularly preferred.

Hydrogen-bearing gases for use in accordance with the present invention include mixtures of a hydrogen gas and a noble gas. Examples of noble gases suitable for use in the process include a gas in Group VIII of the periodic table such as argon, neon, helium and the like. In certain embodiments of the present invention the remotely generated activated chemical species is a gas mixture of hydrogen and helium. In this embodiment, helium functions in part to sustain the hydrogen atom concentration in the gas mixture. For certain embodiments, the amount of hydrogen in the gas mixture is from 1 to 99 percent of the total volume, and more preferably from 10 to 30 percent of the total volume.

In certain embodiments of the present invention, the activated chemical species comprises at least one species selected from CO and CO₂.

In certain embodiments of the present invention, the activated chemical species comprises at least one fluorine-bearing compound. Fluorine-bearing compounds in the gas are preferably less than 10 percent of the total volume of the gas mixture to maximize selectivity. Preferred fluorine compounds include those compounds that generate fluorine reactive species when excited by the employed energy source. Preferably, the fluorine compound is a gas and is selected from a compound having the general formula CₐH_{b}F_{c}, wherein a ranges from 1 to 10, b ranges from 0 to 21 and c ranges from 1 to 22, HF, F₂ and SF₆. Other fluorine bearing compounds that do not generate reactive nitrogen or oxygen species will be apparent to those skilled in the art. More preferably, the fluorine-bearing compound is CF₄, CHF₃, C₃F₈, C₄F₆, C₆F₆, C₄F₈, C₄F₈O, C₂F₆, C₅F₈, or mixtures thereof.

Although exposing the composite film to an activated chemical species alone is sufficient to modify the carbon in the composite film, in certain embodiments of the present invention the step of exposing the composite film to an activated chemical species is preferably performed in cooperation with a step of exposing the composite film to an at least one energy source to more efficiently remove the carbon-containing pore-forming material from the composite film. As used herein, the phrase "in cooperation with a step of exposing the composite film to an at least one energy source" refers to exposing a composite film according to the present invention to both an activated chemical species and an at least one energy source to modify the carbon content of the composite film. Such effect can be achieved when the composite film is exposed concurrently to the activated chemical species and the at least one energy source; when the composite film is exposed to the activated chemical species before the at least one energy source; when the composite film is exposed to the at least one energy source before the activated chemical species; and when the composite film is exposed to the at least one energy source and the activated chemical species in a pulsed manner. As used herein the term "concurrent" or "concurrently" refers to the exposure of the composite to the at least one energy source and the remotely generated activated chemical species at the same time for at least a portion of the exposure time. The duration of the concurrent exposure according to the present invention can be however brief or long as may be required by the particular application.

The cooperative effect of exposing a composite film according to the present invention to both an activated chemical species and an at least one energy source is preferably that the pore-forming material is substantially removed to provide the porous film. As used herein the phrase "substantially removed to provide the porous film" means that the amount of the pore-forming material that remains within the porous film compared to the composite film is at least 50% by weight, preferably at least 25% by weight, more preferably at least 15% by weight, and most preferably at least 5% by weight or less as determined by FTIR, XPS, and other such analytical methods known to those skilled in the art.

The at least one energy source can include, but is not limited to, α-particles, β-particles, γ-rays, x-rays, high energy electron, electron beam sources of energy, heat, ultraviolet (wavelengths from 10 nm to 400 nm), visible (wavelengths from 400 to 750 nm), infrared (wavelengths from 750 to 10⁵ nm), microwave (frequency > 10⁹ Hz), radio-frequency (frequency > 10⁶ Hz), or mixtures thereof. UV radiation alone and UV radiation in combination with heat are the most preferred energy sources.

For example, in certain embodiments wherein the at least one energy source comprises ultraviolet radiation, the temperature that the substrate is subjected to during exposure to the ultraviolet radiation is typically 500°C or less. The composite film may be exposed to one or more wavelengths within the ultraviolet spectrum or one or more wavelengths within the ultraviolet spectrum such as deep ultraviolet light (i.e., wavelengths of 280 nm or below) or vacuum ultraviolet radiation (i.e., wavelengths of 200 nm or below). The ultraviolet radiation may be dispersive, focused, continuous wave, pulsed, scanning, or shuttered. Sources for the ultraviolet radiation include, but are not limited to, an excimer laser, a barrier discharge lamp, a mercury lamp, a microwave-generated UV lamp, a laser such as a frequency doubled or frequency tripled laser in the IR or visible region, or a two-photon absorption from a laser in the visible region. The ultraviolet radiation source may be placed at a distance that ranges from 50 milli-inches to 1,000 feet (1.2 mm to 310 m) from the composite film.

In certain other embodiments, the ultraviolet radiation source is passed through optics to control the environment to which the sample is exposed. By controlling the environment in the chamber, the temperature of the substrate can be kept relatively low during the exposing step by adjusting the ultraviolet light to a particular wavelength.

In embodiments wherein the energy source comprises ultraviolet radiation, the composite film may be exposed to one or more specific wavelengths within the source or a broad spectrum of wavelengths. For example, the composite film may be exposed to one or more particular wavelengths of radiation such as through a laser and/or optically focused light source. In the other embodiments, the radiation source may be passed through optics such as lenses (e.g., convex, concave, cylindrical, elliptical, square or parabolic lenses), filters (e.g., RF filter), windows (e.g., glass, plastic, fused silica, synthetic silica, silicate, calcium fluoride, lithium fluoride, or magnesium fluoride windows) or mirrors to provide specific and focused wavelengths of light. In these embodiments, a non-reactive gas may be flowed over the optics during at least a portion of the exposing step to prevent the formation of build-up on the surface of the optics formed by off-gassing during the pore-formation step. Alternatively, the radiation source may not pass through any optics.

The step of exposing the composite film to at least one energy source may be conducted in a variety of settings depending upon the process used to form the composite film. It may be advantageous for this exposure step to be conducted after or even during at least a portion of the composite film formation step. The exposure step can be performed in various settings such as, but not limited to, a quartz vessel, a modified deposition chamber, a conveyor belt process system, a hot plate, a vacuum chamber, a cluster tool, a single wafer instrument, a batch processing instrument, or a rotating turnstile.

While not intending to be bound by theory, it is believed that the composite film, when exposed to the at least one energy source, absorbs a certain amount of energy to enable removal of the porogen. Depending upon the energy source and the chemistry of the pore-forming material, the chemical bonds within the pore-forming material may be broken thereby facilitating its removal. In this manner, the pore-forming material may be substantially removed from the composite film thereby leaving a porous film that consists essentially of the structure-forming material. The resultant porous film will have a lower density. In some embodiments, the resultant porous film may also have a lower dielectric constant than the composite film. Upon action by the activated chemical species, the porogen interacts with the excited or energetic atoms generated by the plasma as it is removed by the at least one energy source.

There are several significant advantages to the method of the present invention. For example, in certain embodiments of the present invention, at least 90% of the Si-CH₃ species in the as deposited film is typically retained after exposure to the activated chemical species as determined by FTIR. In other embodiments of the present invention, at least 95% of the Si-CH₃ species in the as deposited film is typically retained after exposure to the activated chemical species as determined by FTIR. In other embodiments of the present invention, at least 98% of the Si-CH₃ species in the as deposited film is typically retained after exposure to the activated chemical species as determined by FTIR. Without intending to be bound to any particular theory, it is believed that the process of the present invention can be employed to selectively break carbon-carbon bonds without significantly breaking silicon-carbon bonds such as, for example, those present in the Si-CH₃ species. A typical example is to determine the CH₃-Si/SiO peak area ratio (after baseline correction and normalizing the peak intensity to a 500 nm thick film) from FTIR. In certain embodiments of the present invention, the CH₃-Si/SiO peak ratio in the film exposed to an energy source ranges from 0.005 to 0.035 yet after exposure to an activated chemical species the CH₃-Si/SiO peak area ratio ranges from 0.0015 to 0.03.

The exposure of the film to the at least one energy source in cooperation with the at least one activated chemical species has several advantages in connection with fabricating electronic devices and circuitry. The manipulation of the carbon containing species in the film, both the carbon species covalently bonded to Si and carbon-carbon bonded species, is crucial to the successful integration of porous materials in devices where low dielectric constant materials are needed. The manipulation of the carbon in these films can result in higher tool throughput (improved porogen removal rates, improved cleaning of the optics in the UV chamber, less often cleaning of the optics), better dielectric constant / modulus relationships, and less damage to the film during integration processing. One iteration of this is to "tune" the deposition of the film to increase the cross-linking of the carbon containing porogen precursors in the film and increase the framework density thereby minimizing the shrinkage of the film after porogen removal. The carbon that is not covalently bonded to the Si may act as a protective layer during the etch, ash, and wet clean steps that may help to minimize the chemical damage occurring to the dielectric material. After the trenches and vias are formed, the exposure to an activated chemical species and/or in cooperation with exposure to an energy source will modify the remaining carbon resulting in a porous dielectric material with a low dielectric constant, minimal chemical damage from the etch, ash, wet cleans, and minimal shrinkage to insure that the critical dimensions of the line features are maintained.

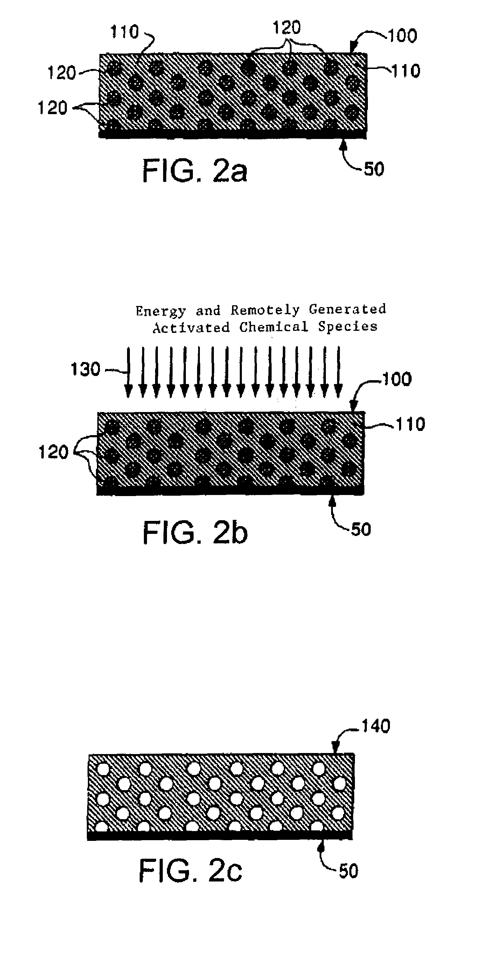

Figures 2a to 2c provide an illustration of an embodiment of the process according to the present invention wherein the composite film is exposed concurrently to at least one energy source (e.g., UV radiation) and an activated chemical species. Referring to Figure 2a, composite film 100 is formed upon at least a portion of a substrate 50. Composite film 100 comprises at least two materials: at least one structure-forming material 110 and at least one pore-forming material 120. In certain preferred embodiments, the structure-forming material 110 is an OSG compound containing primarily Si:O:C:H and the at least one pore-forming material 120 is an organic compound containing primarily C:H. In Figure 2b, composite film 100 is concurrently exposed to one or more energy sources such as, for example, ultraviolet light and a remotely generated activated chemical species, both of which are represented by reference number 130. In certain embodiments, the exposure step depicted in Figure 2b may be conducted at one or more temperatures below 425°C and for a short time interval thereby consuming as little of the overall thermal budget of substrate 50 as possible. Referring now to Figure 2c, the pore-forming material 120 is substantially removed from the composite film 100 leaving a porous film 140. The resultant porous film 140 may have a lower dielectric constant than the composite film 100.

Specific temperature and time durations for the concurrent exposure step may vary depending upon the chemical species included in the composite materials within the mixture. In certain embodiments, the concurrent exposure step is conducted at a temperature of 450°C or less, more preferably between 150°C and 450°C, and most preferably between 250°C and 400°C. The concurrent exposure step is conducted for a time of 60 minutes or less, preferably 30 minutes or less, and more preferably 10 minutes or less. In another embodiment of the present invention, the step of exposing the composite film to at least one energy source and the step of exposing the composite film to an activated chemical species are performed in a pulsed manner. As used herein, the term "pulsed" refers to subjecting the composite film to an alternating exposure of the at least one energy source and the remotely generated activated chemical species comprising a reducing agent. In embodiments where the exposure is pulsed, the pulsing of one can be either in phase or out of phase with the other and the frequency with which the pulsed exposure occurs can be the same or different.

In yet another embodiment, the at least one energy source can be exposed to the composite film continuously and the activated chemical species comprising a reducing agent can be exposed to the composite film in a pulsed manner. In still another embodiment, the at least one energy source can be exposed to the composite film in a pulsed manner and the activated chemical species comprising a reducing agent can be exposed to the composite film continuously.

In certain preferred embodiments of the present invention, the porous film is again exposed to an activated chemical species to further modify carbon in the film in the form of carbon-containing residue. In this regard, a carbon-containing residue may form, for example, from the co-deposition process during the formation of the composite film, upon the modification of at least a portion of the at least one carbon-containing pore-forming material upon exposure of the composite film to at least one energy source and an activated chemical species for a time sufficient to remove at least a portion of the at least one carbon-containing pore-forming material to form a porous film, or at other times during the processing of the film. Applicants have discovered that exposing the porous film to an activated chemical species will at least partially remove the carbon-containing residue and further lower the dielectric constant of the porous film regardless of the origins of the carbon-containing residue.

Accordingly, in another aspect, the present invention provides a process for modifying carbon in a dielectric film, the process comprising: forming onto at least a portion of a substrate a composite film comprising Si, C, O, H and Si-CH₃ groups, wherein the composite film comprises at least one silicon-containing structure-forming material and at least one carbon-containing pore-forming material; exposing the composite film to at least one energy source in cooperation with an activated chemical species for a time sufficient to modify at least a portion of the at least one carbon-containing pore-forming material to form a porous film, and wherein a carbon-containing residue forms upon the modification of at least a portion of the carbon in the film; and exposing the porous film to an activated chemical species to at least partially remove the carbon-containing residue. The dielectric constant of the film is typically further lowered after removal of the carbon-containing residue from the film according to the method of the present invention. The carbon in the porous film may also be introduced during any subsequent processing of the dielectric film to produce the trenches and vias during the construction of electrical devices. This may include photoresists, wet chemical stripper components (corrosion inhibitors, salts, ionic buffers, pH buffers, solvents, etc.), CMP slurry components, CMP cleans, and other rinse steps.

The films produced by the method of the present invention are porous. Total porosity of the film may be from 5 to 75% depending upon the process conditions and the desired final film properties. The average sizes within the porous film ranges from 1 Å (10⁻¹⁰ m) to 500 Å (5 × 10⁻⁸ m), preferably from 1 Å (10⁻¹⁰ m) to 100 Å (10⁻⁸ m), and most preferably from 1 Å (10⁻¹⁰ m) to 50 Å (5 × 10⁻⁹ m). It is preferred that the film have pores of a narrow size range and that the pores are homogeneously distributed throughout the film. The porosity of the film, however, need not be homogeneous throughout the film. In certain embodiments, there is a porosity gradient and/or layers of varying porosities. Such films can be provided by, e.g., adjusting the ratio of pore-forming percursor to structure-forming precursor during formation of the composite film. The porosity of the films may have continuous or discontinuous pores.

In certain embodiments of the present invention, the porous films of the invention have a lower dielectric constant relative to common OSG materials. In certain embodiments, porous films of the invention have a dielectric constant between 2.7 to 1.5. In other embodiments, porous films of the invention have a dielectric constant between 2.7 to 1.8.

In certain embodiments, the dielectric material and film of the present invention are substantially uniform in composition. Compositional uniformity describes a film wherein the composition is relatively uniform with relatively little deviation in composition from the surface to the base of the film. A film that exhibits substantial uniformity in composition may avoid problems associated with the formation of a "skin layer". For example, the use of UV light or electron beams during the exposing and/or treating steps may form a "skin layer" that is compositionally different than the underlying bulk film because the radiation sufficient to remove the pore-former precursor within the composite film only passes through the surface of the film. Further, the removal of the pore-former material near the surface or base of the film can cause integration problems within the device due to a thickness-dependent dielectric constant and hardness for the resulting porous dielectric material.

In certain embodiments, the dielectric material and film have different properties after exposure to the activated chemical species in cooperation with an energy source as described above. Typically, CVD films have an extinction coefficient, as determined from the reflectometry used to measure the thickness and refractive index of the film, that is > 0.01 at 240 nm. Without intending to be bound by any particular theory, a non-zero extinction coefficient indicates that there is a species that is capable of adsorbing ultraviolet light, i.e., the greater the extinction coefficient the greater the amount of carbon containing residue. By combining FTIR analysis and the extinction coefficient from reflectometry it is therefore possible to determine the amount of carbon residue that remains in the film. In preferred embodiments of the present invention the extinction coefficients after exposure to an activated chemical species in cooperation with an energy source results in an extinction coefficient < 0.005 at 240 nm.

The films are suitable for a variety of uses. The films are particularly suitable for deposition on a semiconductor substrate, and are particularly suitable for use as, e.g., an insulation layer, an interlayer dielectric layer and/or an intermetal dielectric layer. The films can form a conformal coating. The properties exhibited by these films make them particularly suitable for use in Al subtractive technology and Cu damascene or dual damascene technology.

The films are compatible with chemical mechanical planarization (CMP) and anisotropic etching, and are capable of adhering to a variety of materials, such as silicon, SiO₂, Si₃N₄, OSG, FSG, silicon carbide, hydrogenated silicon carbide, silicon nitride, hydrogenated silicon nitride, silicon carbonitride, hydrogenated silicon carbonitride, boronitride, antireflective coatings, photoresists, organic polymers, porous organic and inorganic materials, metals such as copper and aluminum, and diffusion barrier layers such as but not limited to TiN, Ti(C)N, TaN, Ta(C)N, Ta, W, or WN.

Although the invention is particularly suitable for providing films and products of the invention are largely described herein as films, the invention is not limited thereto. Products of the invention can be provided in any form such as coatings, multilaminar assemblies, and other types of objects that are not necessarily planar or thin, and a multitude of objects not necessarily used in integrated circuits. Preferably, the substrate is a semiconductor.

The invention will be illustrated in more detail with reference to the following examples, but it should be understood that the present invention is not deemed to be limited thereto.

### EXAMPLES

### Deposition of Composite Films:

The deposition experiments reported in Table I were performed on an Applied Materials Precision-5000 system in a 200mm DxZ chamber fitted with an Advance Energy 2000 rf generator, using an undoped TEOS process kit. Table 1 summarizes the deposition of composite films with various carbon-containing porogens according to the present invention. Films #2, #3, #4, #5, #6 behaved similarly to film #1 upon exposure. Each of these composite films can be treated first with an activated chemical species followed by an energy source, concurrently exposed to an activated chemical species and energy source, or exposed to an energy source followed by exposure to an activated chemical species. Examples 2-8 are prophetic examples of the concurrent exposure of an energy source with a remotely generated activated chemical species on film #1. Examples 9 to 13 and 15 to 20 are also prophetic.

**Table I**

| Film | Mixture | Power (watts) | Spacing (mils) | Pressure (torr) | Temp. (°C) | Liquid Flow (sccm) | Carrier Flow (sccm) | O₂ Flow (sccm) |
|---|---|---|---|---|---|---|---|---|
| 1 | 70:30 ATRP: DEMS | 750 | 350 (8.9 mm) | 8 (1.1 kPa) | 300 | 965 | 200; CO₂ | 25 |
| 2 | 70:30 LIMO:DEMS | 600 | 350(8.9 mm) | 8 (1.1 kPa) | 300 | 750 | 200; CO₂ | 10 |
| 3 | 40:60 NBDE:DEMS | 600 | 350 (8.9 mm) | 8 (1.1 kPa) | 300 | 800 | 200; CO₂ | 0 |
| 4 | 80:20 C8:DEMS | 600 | 350 (8.9 mm) | 8 (1.1 kPa) | 300 | 700 | 200; CO₂ | 20 |
| 5 | 80:20 C8:DEMS | 800 | 350 (8.9 mm) | 8 (1.1 kPa) | 300 | 700 | 200; CO₂ | 20 |
| 6 | 50:50 ENB:DEMS | 700 | 400 (10.2 mm) | 8(1.1 kPa) | 300 | 700 | 300; He | 10 |

| | | | | | | | | |
|---|---|---|---|---|---|---|---|---|
| ATRP - alpha-terpinene; LIMO - limonene; NBDE - 2,5-norbornadiene; C8 - cyclooctane; ENB - ethylenenorbornadiene; DEMS - diethoxymethylsilane | | | | | | | | |

### Example 1.

Composite films were deposited onto a Si substrate using PE-CVD processing techniques. The composite film was exposed to the UV source as described in Example 1 for 5 minutes. After 5 minutes, the wafer was removed from the chamber and cleaned with oxygen in the presence of UV light for 10 minutes to remove porogen from the window. After purging the chamber with helium, the sample was re-introduced into the chamber and exposed to UV light for an additional 8 minutes under a helium purge (250 sccm He flow rate, chamber pressure of 2 Torr, 270 Pa) at 400°C. The chamber was subsequently cleaned with oxygen in the presence of UV light for an additional 5 minutes. The dielectric constant of the film was 2.5, refractive index of 1.36, and an extinction coefficient at 240 nm of 0.032.

### Example 2:

As illustrated in these examples, the concurrent exposure of composite films to an energy source and a remotely generated activated chemical species effectively and efficiently removes the porogen component of the composite film.

Composite films are deposited onto a Si substrate using PE-CVD processing techniques as described above, film #1. An activated source of hydrogen is supplied to the UV chamber by a down stream microwave assisted plasma generator with an ion trap to significantly remove the ions from the gas stream. The following conditions are used for the downstream microwave plasma and UV chamber:
*Microwave plasma:* 1.5 torr (200 Pa); 5000 sccm 5% H₂/He; temperature 350°C; power 1500 watts
*UV source:* 6000 watt broad band bulb (Fusion H+), 100% power, vacuum (<200 mTorr, <25 Pa), 400°C, 5 minutes

The samples are exposed to the combined activated hydrogen and UV light for 5 minutes with the platen in the UV chamber at 400°C. Upon exposure of the composite film, the porogen is significantly removed from the film resulting in films with a dielectric constant of 2.2, refractive index of ~1.3, and an extinction coefficient of 1x10⁻⁴ or less at 240 nm. The use of activated hydrogen with UV curing of composite films increases the rate of porogen removal from the film.

### Example 3:

Composite films are deposited onto a Si substrate using PE-CVD processing techniques. An activated source of hydrogen is supplied to an e-beam chamber by a down stream microwave assisted plasma generator with an ion trap to significantly remove the ions from the gas stream. The following conditions are used for the downstream microwave plasma and e-beam chamber:
*Microwave plasma:*
   1.5 torr (200 Pa); 5000 sccm 5% H₂/He; temperature 350°C; power 1500 watts
*E-beam source:*
   accelerating voltage 4 KeV, amperage 3 mA, 1000µC dosage, 400°C

The samples are exposed to the combined activated hydrogen and e-beam with the platen in the chamber at 400°C until the dosage reached 1000µC. Upon exposure of the composite film, the porogen is significantly removed from the film resulting in films with a dielectric constant of 2.5, refractive index of ~1.3, and an extinction coefficient at 240 nm of 1×10⁴ or less. The use of activated species also increases the rate of porogen removal with other energy sources.

### Example 4:

Composite films are deposited onto a Si substrate using PE-CVD processing techniques. An activated source of hydrogen is supplied to the UV chamber by a down stream microwave assisted plasma generator with an ion trap to significantly remove the ions from the gas stream. The following conditions were used for the downstream microwave plasma and UV chamber:
*Microwave plasma:*
   1.5 torr (200 Pa); 4990 sccm 5% H₂/He; 10 sccm CF₄, temperature 350°C; power 1500 watts
*UV source:*
   6000 watt broad band bulb (Fusion H+), 100% power, vacuum (<200 mTorr, <25 Pa), 400°C, 5 minutes

The samples are exposed to the combined activated hydrogen and UV light for 4 minutes with the platen in the UV chamber at 400°C. Upon exposure of the composite film, the porogen is significantly removed from the film resulting in films with a dielectric constant of 2.2, refractive index of ~1.3, and an extinction coefficient of 1x10⁻⁴ or less at 240 nm. The addition of fluorocarbons increases the efficiency of the porogen removal process.

### Example 5:

Composite films are deposited onto a Si substrate using PE-CVD processing techniques. An activated source of hydrogen is supplied to the UV chamber by a down stream microwave assisted plasma generator with an ion trap to significantly remove the ions from the gas stream. The following conditions are used for the downstream microwave plasma and UV chamber:
*Microwave plasma:*
   1.5 torr (200 Pa); 5000 sccm 5% H₂/He; temperature 350°C; power 1500 watts
*UV source:*
   6000 watt broad band bulb (Fusion H+), 100% power, vacuum (<200 mTorr, <25 Pa), 400°C, 5 minutes

The above process is repeated with 10 composite films without cleaning the windows or chamber in between wafers. After the 10^{th} wafer, the transparency of the window only decreases by 1% in the region between 200 and 360 nm. This example is directly compared with example 2 where the windows have to be cleaned between each wafer. This suggests that the windows in the chamber do not need to be cleaned as often. Also, because porogen decomposition products do not build-up significantly on the windows, the throughput of the tool and the overall process is increased.

### Example 6:

Composite films are deposited onto a Si substrate using PE-CVD processing techniques. An activated source of hydrogen is supplied to a thermal cure chamber by a down stream microwave assisted plasma generator with an ion trap to significantly remove the ions from the gas stream. The following conditions are used for the downstream microwave plasma and e-beam chamber:
*Microwave plasma:*
   1.5 torr (200 Pa); 5000 sccm 5% H₂/He; temperature 350°C; power 1500 watts
*Thermal cure:*
   400°C, vacuum (<200 mTorr, <25 Pa)

The samples are exposed to the combined activated hydrogen and thermal cure at 400°C for 10 minutes. Upon exposure of the composite film to the activated hydrogen source and thermal energy, the porogen is significantly removed from the film resulting in films with a dielectric constant of 2.6, refractive index of ~1.3, and an extinction coefficient at 240 nm of 1x10⁻⁴ or less. The use of activated species also increases the rate of porogen removal use a thermal cure process; typical thermal cure take 20-30 minutes under inert purge.

### Example 7:

Composite films comprising DEMS and a carbon-containing porogen are deposited onto a Si substrate using PE-CVD processing techniques. An activated source of hydrogen is supplied to the UV chamber by a down stream microwave assisted plasma generator with an ion trap to significantly remove the ions from the gas stream. The following conditions are used for the downstream microwave plasma and UV chamber:
*Microwave plasma:*
   1.5 torr (200 Pa); 5000 sccm 5% H₂/He; temperature 350°C; power 1500 watts
*UV source:*
   6000 watt broad band bulb (Fusion H+), 100% power, atmospheric pressure (~760 torr, 100 kPa, He), 400°C, 5 minutes

The samples are exposed to the combined activated hydrogen and UV light for 5 minutes with the platen in the UV chamber at 400°C. Upon exposure of the composite film, the porogen is significantly removed from the film resulting in films with a dielectric constant of 2.5, refractive index of ~1.3, and an extinction coefficient of 1x10⁻⁴ or less at 240 nm. The pressure in the chamber, *i.e.,* vacuum or inert gas at atmospheric conditions, does not affect the amount or rate of porogen removed from the film.

### Example 8.

Composite films comprising DEMS and a carbon-containing porogen are deposited onto a Si substrate using PE-CVD processing techniques. An activated source of hydrogen is supplied to the UV chamber by a down stream microwave assisted plasma generator with an ion trap to significantly remove the ions from the gas stream. The following conditions are used for the downstream microwave plasma and UV chamber:
*Microwave plasma:*
   1.5 torr (200 Pa); 5000 sccm 5% H₂/He; temperature 350°C; power 1500 watts
*UV source:*
   6000 watt broad band bulb (Fusion H+), 100% power, vacuum (<200 mTorr, <25 Pa), 300°C, 5 minutes

The samples are exposed to the combined activated hydrogen and UV light for 5 minutes with the platen in the UV chamber at 300°C. Upon exposure of the composite film, the porogen is significantly removed from the film resulting in films with a dielectric constant of 2.5, refractive index of ~1.3, and an extinction coefficient of 1×10⁻⁴ or less at 240 nm. The use of activated hydrogen with UV curing of composite films increases the rate of porogen removal from the film at temperatures less than 400°C.

### Example 9.

This example shows the remote source being a microwave plasma source used concurrently with hot filament to remove porogen.

Composite films comprising DEMS and a carbon-containing porogen are deposited onto a Si substrate using PE-CVD processing techniques. An activated source of hydrogen is supplied to the HFCVD chamber by a down stream microwave assisted plasma generator with an ion trap to significantly remove the ions from the gas stream. The following conditions are used for the downstream microwave plasma and HFCVD chamber:
*Microwave plasma:*
   1.5 torr (200 Pa); 5000 sccm 5% H₂/He; temperature 350°C; power 1500 watts
*HFCVD:*
   Filaments heated to 1000°C, H₂ gas supplied to the filaments, susceptor temperature is 400°C

The samples are exposed to the combined activated hydrogen and hot filament energy source for 5 minutes with the platen in the HFCVD chamber at 400°C. Upon exposure of the composite film, the porogen is substantially removed from the film resulting in films with a dielectric constant of 2.5, refractive index of ~1.3, and an extinction coefficient of 1x10⁻⁴ or less at 240 nm. The use of hot filament technology combined with remote microwave plasma sources results in an increase in the activated chemical species.

### Example 10.

This example shows the use of hot filament to generate activated chemical species to remove porogen.

Composite films comprising DEMS and a carbon-containing porogen are deposited onto a Si substrate using PE-CVD processing techniques. An activated source of hydrogen is created by the HFCVD chamber by passing hydrocarbons or hydrogen gas mixtures through the hot filament thereby creating activated species in situ. The following conditions are used for the HFCVD chamber:
*HFCVD:*
   Filaments heated to 1000°C, H₂ gas supplied to the filaments, susceptor temperature is 400°C

The samples are exposed to the activated chemical species generated from the hot filaments for 5 minutes with the platen in the HFCVD chamber at 400°C. Upon exposure of the composite film, the porogen is substantially removed from the film resulting in films with a dielectric constant of 2.5, refractive index of ~1.3, and an extinction coefficient of 1x10⁻⁴ or less at 240 nm. The use of *in situ* activated hydrogen produced in the HFCVD chamber increases the rate of porogen removal from the composite film at temperatures less than 400°C.

### Example 11.

This example shows the use of hot filament as the remote source concurrently with UV to generate activated chemical species to remove porogen.

Composite films comprising DEMS and a carbon-containing porogen are deposited onto a Si substrate using PE-CVD processing techniques. An activated source of hydrogen is supplied to the UV chamber by a hot filament remote source. The following conditions are used for the hot filament source and UV chamber:
*Hot filament:*
   filament temperature = 1000°C, H₂ gas supplied to the filaments
*UV source:*
   6000 watt broad band bulb (Fusion H+), 100% power, vacuum (<200 mTorr, <25 Pa), 300°C, 5 minutes

The samples are exposed to the combined activated hydrogen and UV light for 5 minutes with the platen in the UV chamber at 300°C. Upon exposure of the composite film, the porogen is substantially removed from the film resulting in films with a dielectric constant of 2.5, refractive index of ~1.3, and an extinction coefficient of 1x10⁻⁴ or less at 240 nm. The use of activated hydrogen with UV curing of composite films increases the rate of porogen removal from the film at temperatures less than 400°C.

### Example 12.

This example shows the use of hot filament as the remote source to generate activated chemical species concurrently with a thermal energy source to remove porogen.

Composite films comprising DEMS and a carbon-containing porogen are deposited onto a Si substrate using PE-CVD processing techniques. An activated source of hydrogen is supplied to the thermal cure chamber by a hot filament source. The following conditions are used for the hot filament source and thermal cure:
*Hot filament:*
   filament temperature = 1000°C, H₂ gas supplied to the filaments
*Thermal cure:*
   400°C, vacuum (<200 mTorr, <25 Pa)

The samples are exposed to the combined activated hydrogen and thermal cure for 5 minutes with the platen in the chamber at 300°C. Upon exposure of the composite film, the porogen is substantially removed from the film resulting in films with a dielectric constant of 2.5, refractive index of ~1.3, and an extinction coefficient of 1x10⁻⁴ or less at 240 nm. The use of activated hydrogen with thermal curing of composite films increases the rate of porogen removal from the film at temperatures less than 400°C.

### Example 13.

This example shows the use of hot filament as the remote source concurrently with e-beam to generate activated chemical species to remove porogen.

Composite films comprising DEMS and a carbon-containing porogen are deposited onto a Si substrate using PE-CVD processing techniques. An activated source of hydrogen is supplied to the e-beam chamber by a hot filament source. The following conditions are used for the hot filament and e-beam sources:
*Hot filament:*
   filament temperature = 1000°C, H₂ gas supplied to the filaments
*E-beam source:*
   accelerating voltage 4 KeV, amperage 3 mA, 1000µC dosage, 400°C

The samples are exposed to the combined activated hydrogen and e-beam for 5 minutes with the platen in the UV chamber at 300°C. Upon exposure of the composite film, the porogen is substantially removed from the film resulting in films with a dielectric constant of 2.5, refractive index of ~1.3, and an extinction coefficient of 1x10⁻⁴ or less at 240 nm. The use of activated hydrogen with e-beam curing of composite films increases the rate of porogen removal from the film at temperatures less than 400°C.

### Example 14.

This example shows the use of UV to remove a portion of the porogen from the film followed by the use a remote plasma source to remove any carbon not removed during the UV cure (e.g., carbon-containing residue).

Composite films comprising DEMS and a carbon-containing porogen were deposited onto a Si substrate using PE-CVD processing techniques. The film was UV cured for 10 minutes to render the film porous. The conditions for the UV is listed below:
*UV source:*
   6000 watt broad band bulb (Fusion H+), 100% power, vacuum (<200 mTorr, <25 Pa), 300°C, 5 minutes
*Microwave plasma:*
   1.2 torr (160 Pa); 1000 sccm 5% H₂/He; 10 sccm CF₄; temperature 300°C; power 1500 watts

After the UV cure, the sample was then treated for 3 minutes with the microwave plasma source. The dielectric constant after the UV cure is 2.5, refractive index was 1.36, the methyl content from FTIR (CH₃-Si/SiO) was 0.022m and the hydrocarbon content from FTIR (CH₃-Si/HC) was 0.94. After the microwave plasma treatment with hydrogen, the dielectric constant was lowered from 2.5 to 2.35. There was no methyl content change in the film and the amount of hydrocarbon decreases by 32%. There were no changes in the mechanical properties of the film.

### Example 15.

This example shows the use of e-beam to remove a portion of the porogen from the film followed by the use a remote plasma source to remove any carbon not removed during the UV cure.

Composite films comprising DEMS and a carbon-containing porogen are deposited onto a Si substrate using PE-CVD processing techniques. The first step is the removal of a portion of the porogen from the composite film to produce a porous film. The following conditions are used for the e-beam and remote plasma:
*E-beam source:*
   accelerating voltage 4 KeV, amperage 3 mA, 1000µC dosage, 400°C
*Microwave plasma:*
   1.2 torr (160 Pa); 1000 sccm 5% H₂/He; 10 sccm CF₄; temperature 300°C; power 1500 watts

After the porogen is removed substantially, the porous film is further treated with a remote plasma to generate the activated chemical species. The activated chemical species removes the carbon containing species that were not removed from the porous film. Upon exposure of the composite film, the porogen is significantly removed from the film resulting in films with a dielectric constant of 2.7, refractive index of ~1.39, and an extinction coefficient of 0.07 or more at 240 nm. The use of activated hydrogen removes the excess carbon containing species from the film resulting in a dielectric constant of 2.4, refractive index of 1.35, and 1×10⁻⁴ extinction coefficient at 240 nm.

### Example 16.

This example shows the use of a thermal treatment to remove a portion of the porogen from the film followed by the use a remote plasma source to remove any carbon containing species not removed during the thermal cure.

Composite films comprising DEMS and a carbon-containing porogen are deposited onto a Si substrate using PE-CVD processing techniques. The composite film is initially treated at 400°C for 20 minutes to partially remove the carbon containing species from the film to create a porous film. The following conditions are used for the thermal and plasma sources:
*Microwave plasma:*
   1.5 torr (200 Pa); 5000 sccm 5% H₂/He; temperature 350°C; power 1500 watts
*Thermal cure:*
   400°C, vacuum (<200 mTorr, <25 Pa)

The samples are exposed to the activated hydrogen from the microwave plasma system for 5 minutes. The remaining carbon-containing species that were not removed during the thermal cure appear to be removed from the film after treatment with activated hydrogen. After thermal cure the dielectric constant of the film is 2.85, the refractive index is 1.40, and there is a significant amount of hydrocarbon apparent in the FTIR of the film. Treatment with activated chemical species reduces the dielectric constant to 2.6, refractive index decreases to 1.37, and the hydrocarbon in the film is reduced.

### Example 17.

This example shows the use of an activated chemical species to modify the carbon containing porogen in the composite film followed by the use of an energy source, e.g. UV light, to remove the modified carbon containing porogen.

Composite films comprising DEMS and a carbon-containing porogen are deposited onto a Si substrate using PE-CVD processing techniques. The composite film is initially treated with an activated hydrogen source for 5 minutes to modify the carbon containing porogen in the pore system of the film. After the modification of the carbon containing species, the composite film is transferred to a UV chamber where it is cured at 350°C for 4 minutes. The following conditions are used for the plasma and UV sources:
*Microwave plasma:*
   1.5 torr (200 Pa); 5000 sccm 5% H₂/He; temperature 350°C; power 1500 watts
*UV source:*
   6000 watt broad band bulb (Fusion H+), 100% power, vacuum (<200 mTorr, <25 Pa), 350°C

After treatment with the activated chemical species and UV light, the dielectric constant of the film is 2.35, RI is 1.35, and the extinction coefficient at 240 nm is 0.006. The dielectric constant of the a film treated in this manner is 5-10% lower and cured faster than a film treated with UV light alone.

### Example 18.

This example shows the use of an activated chemical species to modify the carbon containing porogen in the composite film followed by an e-beam exposure to remove the modified carbon containing porogen.

Composite films comprising DEMS and a carbon-containing porogen are deposited onto a Si substrate using PE-CVD processing techniques. The composite film is initially treated with an activated hydrogen source for 5 minutes to modify the carbon containing porogen in the pore system of the film. After the modification of the carbon containing species, the composite film is transferred to an e-beam chamber where it is cured at 350°C for 4 minutes. The following conditions are used for the plasma and e-beam sources:
*Microwave plasma:*
   1.5 torr (200 Pa); 5000 sccm 5% H₂/He; temperature 350°C; power 1500 watts
*E-beam source:*
   accelerating voltage 4 KeV, amperage 3 mA, 1000µC dosage, 350°C

After treatment with the activated chemical species and e-beam, the dielectric constant of the film is 2.41, RI is 1.36, and the extinction coefficient at 240 nm is 0.003. The dielectric constant of the a film treated in this manner is 5-10% lower and cured faster than a film treated with an e-beam cure alone.

### Example 19.

This example shows the use of an activated chemical species to modify the carbon containing porogen in the composite film followed by thermal treatment, i.e., a furnace, hot plate, rapid thermal process chamber, to remove the modified carbon containing porogen.

Composite films comprising DEMS and a carbon-containing porogen are deposited onto a Si substrate using PE-CVD processing techniques. The composite film is initially treated with an activated hydrogen source for 5 minutes to modify the carbon containing porogen in the pore system of the film. After the modification of the carbon containing species, the composite film is transferred to a hot plate under inert atmosphere at 400°C for 3 minutes. The following conditions are used for the plasma source:
*Microwave plasma:*
   1.5 torr (200 Pa); 5000 sccm 5% H₂/He; temperature 350°C; power 1500 watts

After treatment with the activated chemical species and thermal treatment, the dielectric constant of the film is 2.44, RI is 1.36, and the extinction coefficient at 240 nm is 0.003. The dielectric constant of the a film treated in this manner is cured faster and capable of removing a majority of the carbon containing porogen than a film treated with a thermal cure alone.

### Example 20.

This example shows the use of an activated chemical species and UV light source to remove carbon containing porogen that is cross linked, i.e., difficult to remove under standard curing conditions, in the pore structure of a DEMS/porogen composite film. These types of films, modified by the deposition conditions in the PE-CVD chamber, tend have to higher density networks resulting in little shrinkage during the porogen removal portions of the process to produce a porous dielectric film. The other implications with this type of film is that the carbon containing porogen could be retained in the film during the formation of the trenches and vias and subsequently removed at a later stage to provide the porous low dielectric constant film. The chemical and physical damage incurred from the etch, ash, and wet clean processes would be minimized without sacrificing critical dimension control of the metal lines.

Composite films comprising DEMS and a carbon-containing porogen are deposited onto a Si substrate using PE-CVD processing techniques. One set of conditions to increase the network connectivity while forming intractable carbon containing species are demonstrated in table 1, film 5. There are a multitude of other deposition process parameters that can be adjusted to alter the framework density and type / form of carbon containing porogen species including temperature, pressure, spacing, and power.

The composite film is initially treated with an activated hydrogen source for 10 minutes to modify the carbon containing porogen in the pore system of the film. After the modification of the carbon containing species, the composite film is transferred to a UV chamber where it is cured at 400°C. The cure sequence is to expose the sample to 4 minutes of UV light at 400°C, remove the wafer from the UV chamber, clean the UV chamber with oxygen in the presence of UV light for 5 minutes, purge the chamber to remove any oxygen from the clean procedure, put the wafer back into the chamber. The process is repeated two additional times (total of 3 cure steps and 3 clean steps; 4+4+4 UV curing sequence). The following conditions are used for the plasma and UV sources:
*Microwave plasma:*
   0.5 torr (67 Pa); 5000 sccm 50% H₂/He; temperature 350°C; power 1500 watts
*UV source:*
   6000 watt broad band bulb (Fusion H+), 100% power, vacuum (<200 mTorr, <25 Pa)

After treatment with the activated chemical species and UV light, the dielectric constant of the film is 2.55, RI is 1.37, and the extinction coefficient at 240 nm is 0.02. The shrinkage of the film, i.e. the percent change in thickness of the cured film relative to the composite film, after curing was <2%. Although the dielectric constant of the film is not significantly reduced in comparison to the activated chemical species followed by UV treatment under milder deposition conditions, this suggests that we are able to remove carbon from the film at any time during the process without causing excessive shrinkage of the film upon porogen removal.

The foregoing examples and description of the preferred embodiments should be taken as illustrating, rather than as limiting the present invention as defined by the claims. As will be readily appreciated, numerous variations and combinations of the features set forth above can be utilized without departing from the present invention as set forth in the claims. Such variations are not regarded as a departure from the scope of the invention, and all such variations are intended to be included within the scope of the following claims.

## Claims

1. A process for forming a porous film and/or for modifying carbon in a dielectric film, the process comprising:
forming onto at least a portion of a substrate a composite film comprising Si, C, O, H and Si-CH₃ species, wherein the composite film comprises at least one silicon-containing structure-forming material and at least one carbon-containing pore-forming material and
exposing the composite film to an activated chemical species.

2. A process for forming a porous dielectric film as claimed in Claim 1, wherein the step of exposing the composite film to an activated chemical species is to at least partially modify the carbon-containing pore-forming material, and wherein at least 90% of Si-CH₃ species in the as deposited film remains in the film after the exposing step as determined by FTIR.

3. A process for forming a porous film as claimed in Claim 1, wherein the composite film is exposed concurrently to at least one energy source and the activated chemical species.

4. A process for modifying carbon in a dielectric film as claimed in Claim 1, the process comprising:
exposing the composite film to at least one energy source in cooperation with an activated chemical species for a time sufficient to modify at least a portion of the at least one carbon-containing pore-forming material to form a porous film, and wherein a carbon-containing residue forms upon the modification of at least a portion of the carbon in the film; and
exposing the porous film to an activated chemical species to at least partially remove the carbon-containing residue.

5. The process of any one of the preceding claims wherein the activated chemical species is formed by exposing a gas to a radio frequency energy source or to a hot filament energy source or to an electron attachment energy source, wherein the gas comprises a gas selected from H₂, CO, CO₂, a C₁₋₁₀ linear or branched, cyclic or multicyclic, saturated, or unsaturated hydrocarbon, hydrazine and its derivatives, sulfur and its oxides, H₂S, hydrides, boranes, ammonia, amines, silane, organosilanes, phosphine, arsine, stibine, and mixtures thereof.

6. The process of Claim 5 wherein the radio frequency energy source is a remote radio frequency energy source or the hot filament energy source is a remote hot filament energy source.

7. The process of any one of the preceding claims wherein the at least one silicon-containing structure-forming material is selected from an organosilane, an organosiloxane, and mixtures thereof.

8. The process of any one of the preceding claims wherein the exposing step is performed in cooperation with a step of exposing the composite film to at least one energy source.

9. The process of Claim 8 wherein the step of exposing the composite film to at least one energy source is performed before, concurrently with or after the step of exposing the composite film to an activated chemical species.

10. The process of Claim 8 or Claim 9 wherein the step of exposing the composite film to at least one energy source and the step of exposing the composite film to an activated chemical species are performed in a pulsed manner.

11. The process of any one of Claims 8 to 10 wherein the at least one energy source is selected from: α-particles, β-particles, γ-rays, x-rays, high energy electron, electron beam sources of energy; ultraviolet radiation, heat, visible radiation, infrared radiation, microwave radiation, radio-frequency radiation, hot filaments, and mixtures thereof.

12. The process of Claim 11 wherein the at least one energy source comprises ultraviolet radiation or ultraviolet light and heat.

13. The process of any one of the preceding claims wherein the porous dielectric film is represented by the formula SiᵥO_{w}CₓH_{y}F_{z}, where v+w+x+y+z = 100 atomic%, v is from 10 to 35 atomic%, w is from 10 to 65 atomic%, x is from 5 to 30 atomic%, y is from 10 to 50 atomic%, and z is from 0 to 15 atomic%.

14. The process of any one of the preceding claims wherein the forming step comprises:
providing a substrate within a vacuum chamber;
introducing into the vacuum chamber gaseous reagents including at least one silicon-containing structure-forming precursor gas selected from an organosilane and an organosiloxane, and a carbon-containing pore-forming precursor gas distinct from the at least one silicon-containing structure-forming precursor gas; and
applying energy to the gaseous reagents in the vacuum chamber to induce reaction of the gaseous reagents to deposit the composite film on the substrate.

15. The process of Claim 14 wherein the silicon-containing structure-forming precursor gas comprises at least one of:
(a) an alkylsilane represented by the formula R¹ₙSiR²₄₋ₙ, where n is an integer from 1 to 3; R¹ and R² are independently at least one branched or straight chain C₁ to C₈ alkyl group (e.g., methyl, ethyl), a C₃ to C₈ substituted or unsubstituted cycloalkyl group, a C₃ to C₁₀ partially unsaturated alkyl group, a C₆ to C₁₂ substituted or unsubstituted aromatic, a corresponding linear, branched, cyclic, partially unsaturated alkyl, or aromatic containing alkoxy group, and R² is alternatively hydride;
(b) a linear organosiloxane represented by the formula R¹(R²₂SiO)ₙSiR²₃ where n is an integer from 1 to 10, or cyclic organosiloxane represented by the formula (R¹R²SiO)ₙ where n is an integer from 2 to 10 and R¹ and R² are as defined above; and
(c) a linear organosilane oligomer represented by the formula R²(SiR¹R²)ₙR² where n is an integer from 2 to 10, or cyclic organosilane represented by the formula (SiR¹R²)ₙ, where n is an integer from 3 to 10, and R¹ and R² are as defined above.

16. The process of Claim 15 wherein the silicon-containing structure-forming precursor gas comprises at least one selected from: methylsilane, dimethylsilane, trimethylsilane, tetramethylsilane, phenylsilane, methylphenylsilane, cyclohexylsilane, tert-butylsilane, ethylsilane, diethylsilane, tetraethoxysilane, diethoxymethylsilane, dimethyldiethoxysilane, dimethyldimethoxysilane, dimethylethoxysilane, methyldiethoxysilane, triethoxysilane, trimethylphenoxysilane, phenoxysilane, 1,3,5,7-tetramethylcyclotetrasiloxane, octamethylcyclotetrasiloxane, hexamethylcyclotrisiloxane, hexamethyldisiloxane, 1,1,2,2-tetramethyldisiloxane, and octamethyltrisiloxane.

17. The process of Claim 16 wherein the silicon-containing structure-forming precursor gas comprises diethoxymethylsilane.

18. The process of any one of the preceding claims wherein the carbon-containing pore-forming material is selected from: alpha-terpinene, limonene, cyclohexane, gamma-terpinene, camphene, dimethylhexadiene, ethylbenzene, norbornadiene, cyclopentene oxide, cyclohexene oxide, cyclohexanone, cyclopentanone, 1,2,4-trimethylcyclohexane, 1,5-dimethyl-1,5-cyclooctadiene, camphene, adamantane, 1,3-butadiene, substituted dienes, alpha-pinene, beta-pinene, and decahydronaphthelene, cyclooctane, cyclooctene, cyclooctadiene, cycloheptane, cycloheptene, dimethylhexadiene, and mixtures thereof.

19. The process of Claim 3 or any claim dependent thereon wherein the exposing step is performed for a time sufficient to remove at least a portion of the at least one carbon-containing pore-forming material.

20. The film produced by the process of any one of the preceding claims having an extinction coefficient < 0.005 at 240 nm.
